# EUROPEAN PATENT APPLICATION

(11) **EP 4 663 836 A1**
(43) Date of publication of application: **17.12.2025**
(21) Application number: 24845828.3
(22) Date of filing: 24.06.2024
(51) Int. Cl.: D06F 34/32

(54) **WASHING MACHINE AND HOME APPLIANCE COMPRISING PCB FOR USER INTERFACE PANEL SUPPORTING BOTH ELECTRONIC KEY AND MECHANICAL KEY IN SINGLE AREA**

(30) Priority: 27.07.2023 KR 20230098357; 13.12.2023 KR 20230181169
(71) Applicant: Samsung Electronics Co., Ltd., Suwon-si, Gyeonggi-do 16677 (KR)
(72) Inventor: LEE, Gieun, Suwon-si, Gyeonggi-do 16677 (KR); KIM, Mikyoung, Suwon-si, Gyeonggi-do 16677 (KR)
(74) Representative: Gulde & Partner
(86) International application number: PCT/KR2024/008710
(87) International publication number: WO 2025/023524

(57) **Abstract**

According to one embodiment disclosed herein, a user interface panel on a washing machine comprising a common mounting area in which a mechanical key and an electronic key can be mounted may include a printed circuit board (PCB), and the PCB may comprise: the common mounting area in which the electronic key or the mechanical key can be mounted; a first jumper connecting the common mounting area and a ground; and a plurality of conductive surfaces to which terminals of the mechanical key can be coupled.

## Description

### Technical field

An embodiment of the disclosure relates to a printed circuit board (PCB) on which a touch key and a tact key among input keys which are one type of input interface of a home appliance are mounted.

### Background art

Home appliances may include electric devices and machines used at homes. According to an embodiment of the disclosure, home appliances may include stationary devices or movable devices at home. The term 'home' as herein used may refer to an indoor space such as not only a house but also an office. The home appliances may include a television (TV), a digital video disk (DVD) player, an audio system, a refrigerator, an air conditioner, a vacuum cleaner, an oven, a microwave, a washing machine, an air purifier, a set-top box, a home automation control panel, a security control panel, a media box (e.g., Samsung HomeSync^{™}, Apple TV^{™}, or Google TV^{™}), a game console (e.g., Xbox^{™}, PlayStation^{™}), an electronic dictionary, an electronic key, a camcorder, an electronic frame, a speaker, an electronic reader, a desktop personal computer (PC), a laptop PC, a netbook computer, a workstation, a server, a personal digital assistant (PDA), a portable multimedia player (PMP), an MP3 player, a medical device, a camera, etc. The home appliance may include an input interface for receiving an input from the user and an output interface for outputting information for the user. The input interface may include various types of input interfaces, e.g., touch keys or touch buttons as electronic keys or electronic buttons, tack keys or tack buttons as mechanical keys or mechanical buttons, a voice input, a motion input, etc. As the electronic keys and mechanical keys mounted as the input interface are mounted on a printed circuit board (PCB) in different ways, the PCB needs to be made by predetermining which keys are to be mounted. However, after a PCB pattern is determined, it is difficult to change how the keys are to be arranged and/or mounted.

### Disclosure of Invention

### Technical Solution

According to an embodiment of the disclosure, a washing machine including a common mounting region allowed for a mechanical key and an electronic key to be mounted thereon includes a door through which laundry is loaded in or drawn out, a drum receiving the laundry, a motor rotating the drum for performing the wash, a user interface panel providing information relating to washing of the laundry and receiving a user input, a processor configured to drive the motor or control the motor to perform the wash based on the user input, and a printed circuit board (PCB) used for the user interface panel. In an embodiment of the disclosure, the washing machine may include the common mounting region allowed for the electronic key or the mechanical key for input interface to be mounted thereon. In an embodiment of the disclosure, the washing machine may include a first jumper connecting the common mounting region to ground. In an embodiment of the disclosure, the washing machine may include a plurality of conductive planes to be coupled to terminals of the mechanical key.

According to an embodiment of the disclosure, a home appliance including a common mounting region allowed for a mechanical key and an electronic key to be mounted thereon includes a user interface panel displaying information relating to an operation of the home appliance and receiving a user input. In an embodiment of the disclosure, the home appliance may include a processor configured to control the home appliance based on the user input. In an embodiment of the disclosure, the home appliance may include a PCB used for the user interface panel. In an embodiment of the disclosure, the PCB may include a common mounting region allowed for an electronic key or a mechanical key for input interface to be mounted thereon. In an embodiment of the disclosure, the PCB may include a first jumper connecting the common mounting region to the ground. In an embodiment of the disclosure, the common mounting region of the PCB may include a plurality of conductive planes to be coupled with terminals of the mechanical key. In an embodiment of the disclosure, when the electronic key is mounted in the common mounting region of the PCB, the first jumper is opened, and when the mechanical key is mounted in the common mounting region, the first jumper is short-circuited.

### Brief Description of Drawings

FIG. 1A is a perspective view of a washing machine as a home appliance, according to an embodiment of the disclosure.
FIG. 1B is a cross-sectional view of a washing machine as a home appliance, according to an embodiment of the disclosure.
FIG. 2 illustrates a user interface panel of a home appliance, according to an embodiment of the disclosure.
FIG. 3 is a diagram of a printed circuit board (PCB) of a user interface panel of a home appliance, according to an embodiment of the disclosure.
FIG. 4A illustrates a mechanical key as an input key, according to an embodiment of the disclosure.
FIG. 4B illustrates a mechanical key as an input key, according to an embodiment of the disclosure.
FIG. 4C is a cross-sectional view of a mechanical key as an input key, according to an embodiment of the disclosure.
FIG. 5 illustrates an operation of an electronic key, according to an embodiment of the disclosure.
FIG. 6 illustrates a copper foil form of an electronic key and mechanical key mounting region.
FIG. 7A illustrates a copper foil form of a common mounting region that may be shared by electronic and mechanical keys, according to an embodiment of the disclosure.
FIG. 7B illustrates a copper foil form that exposes a common mounting region in which both electronic and mechanical keys may be mounted, according to an embodiment of the disclosure.
FIG. 8 is a top view of a common mounting region where a mechanical key and an electronic key are mounted, according to an embodiment of the disclosure.
FIG. 9 is a circuit diagram including a common mounting region, according to an embodiment of the disclosure.
FIG. 10 is circuit diagram including a common mounting region, according to an embodiment of the disclosure.
FIG. 11 is a circuit diagram of a case that a mechanical key is coupled to a common mounting region, according to an embodiment of the disclosure.
FIG. 12 is a circuit diagram of a case that an electronic key is mounted in a common mounting region, according to an embodiment of the disclosure.
FIG. 13 is a diagram illustrating types of electronic keys, according to an embodiment of the disclosure.
FIG. 14 is a flowchart of a process of producing a PCB that includes a common mounting region, according to an embodiment of the disclosure.
FIG. 15 is a block diagram of a home appliance, according to an embodiment of the disclosure.
FIG. 16 is a perspective view of an air conditioner, according to an embodiment of the disclosure.
FIG. 17 illustrates a cleaner among home appliances, according to an embodiment of the disclosure.
FIG. 18 is a perspective view of an electric oven among home appliances, according to an embodiment of the disclosure.
FIG. 19 is a perspective view of an induction device, according to an embodiment of the disclosure.

### Mode for the Invention

Terms as used herein will be described before detailed descriptions of an embodiment of the disclosure are provided.

The terms are selected as common terms that are currently widely used, taking into account principles of the disclosure, which may however depend on intentions of those of ordinary skill in the art, judicial precedents, emergence of new technologies, and the like. Some terms as used herein are selected at the applicant's discretion, in which case, the terms will be explained later in detail in connection with embodiments of the disclosure. Therefore, the terms should be defined based on their meanings and descriptions throughout the disclosure.

Throughout the disclosure, the expression "at least one of a, b or c" indicates only a, only b, only c, both a and b, both a and c, both b and c, all of a, b, and c, or variations thereof.

The term "include (or including)" or "comprise (or comprising)" is inclusive or open-ended and does not exclude additional, unrecited elements or method steps. The terms "unit", "module", "block", etc., as used herein each represent a unit for handling at least one function or operation, and may be implemented in hardware, software, or a combination thereof.

An embodiment of the disclosure will now be described in detail with reference to accompanying drawings so as to be readily practiced by those of ordinary skill in the art. However, an embodiment of the disclosure may be implemented in many different forms, and is not limited to embodiments as will be discussed herein. In the drawings, parts unrelated to the description are omitted for clarity, and like numerals refer to like elements throughout the specification.

A washing machine is a device for washing clothes with electric power, and commonly includes a water tank for storing water and a drum for separating contaminants from the clothes by spinning in the water tank.

The washing machine may be classified into one that performs the wash the way a pulsator rotates and one that performs the wash the way a drum rotates.

Alternatively, there is a washing machine that performs the wash with a drum horizontally arranged and rotating around the horizontal axis, in which case the clothes are lifted and fall along the inner circumferential surface of the drum, and a washing machine that performs the wash by using water current generated by a pulsator equipped in a drum vertically arranged and rotating around the vertical axis.

The washing machine with the drum rotating around the vertical axis includes both the drum and the pulsator to enhance washing performance and washes the clothes by rotating the pulsator, and there is a washing machine that operates the drum along with the rotation of the pulsator to cause a drop of the clothes while rotating the pulsator in the opposite direction to the drum to generate friction.

Throughout the specification, the term washing machine may be interchangeably used with washer or washing home appliance.

In an embodiment of the disclosure, a PCB designing method by which both a touch key and a tack key among input interfaces of the home appliance are mounted on the PCB, and a PCB device made according to the PCB designing method are required.

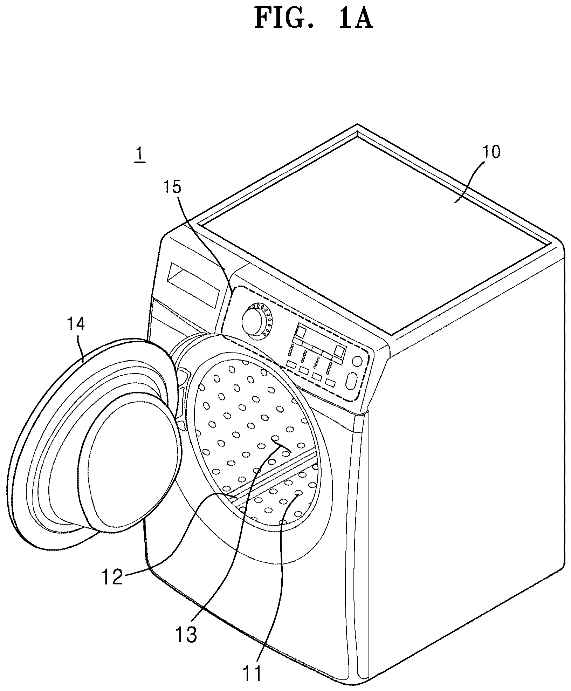

FIG. 1A is a perspective view of a washing machine as a home appliance, according to an embodiment of the disclosure.

In FIG. 1A, a washing machine 1 may include a main body 10, a water tank (not shown) installed in the main body 10, and a drum 11 installed in the water tank. A lifter 12 may be installed on the inner side of the drum 11, which lifts the clothes while the drum 11 is rotating and has them fall by gravity. The drum 11 may perform washing, rinsing and/or spin-drying (or dehydrating) while rotating in a tub as will be described below. The drum 11 may include through holes that connect between internal space of the drum 11 and internal space of the tub. The drum 11 may have substantially a cylindrical shape with one side open.

The main body 10 may be normally shaped like a hexahedron, but is not limited thereto. An opening 13 may be formed in the front center of the main body 10 to throw, i.e., load, the clothes into or draw them out of the drum 11, and a door 14 may be rotationally installed to open or close the opening 13. At least a portion of the door 14 may be transparent or translucent for the inside of the drum 11 to be seen.

Although not shown in FIG. 1A, the washing machine 1 may include the tub arranged in the water tank to store water. The tub may be supported inside the water tank. The tub may have substantially a cylindrical shape with one side open. The tub may be elastically supported by a damper from the water tank. The damper may connect the water tank to the tub. When vibration generated while the drum 11 is rotating is delivered to the tub and/or the water tank, the damper may be arranged to damp down, e.g., reduce, the vibration by absorbing vibration energy between the tub and the water tank.

A user interface panel 15 may be installed on the upper front of the main body 10 to display an operation state and/or information relating to washing of the washing machine 1 for the user or allow the user to control a laundry operation in person. The user interface panel 15 may include an input, e.g., an input interface, through which to receive an operation command from the user and a display as an output interface through which to display operation information of the washing machine. The input interface may receive an input, and may be established using an electronic device that operates according to one or more touch keys that operate by the user's physical touch and/or one or more mechanical keys that operate by the user's physical push. The user interface panel 15 will be described in detail later.

The input, e.g., an input interface, may provide an electrical output signal corresponding to a user input to a controller (not shown in FIG. 1A) including a processor. The input may include, for example, a power button, an operation button, a course selection dial (or course selection buttons) and washing/rinsing/dehydrating setting buttons as input buttons. The input buttons may include, for example, a tact key, a push key, a slide switch, a toggle switch, and a micro switch as mechanical keys, and touch keys as electronic keys.

The display may receive a signal from the processor and display information corresponding to the received signal. The display may include a screen for displaying a laundry course selected by turning the course selection dial (or by pressing the course selection button) and an operation time of the washing machine, and an indicator for indicating a washing setting/rinsing setting/dehydration setting selected by the setting button. The display may include, for example, a liquid crystal display (LCD) panel, a light emitting diode (LED) panel, or the like.

Although not shown in FIG. 1A, the washing machine 1 may include a driver configured to rotate the drum 11.

The driver (not shown in FIG. 1A) may include a driving motor and a rotation shaft (not shown) for delivering driving force generated from the driving motor to the drum 11. A rotation shaft may pass through the tub and be connected to the drum 11. The driver may be configured to perform washing, rinsing and/or dehydration by rotating the drum 11 forwardly or reversely.

A water supplier (not shown) may supply water into the tub. The water supplier may include a water supply tube and a water supply valve arranged at the water supply tube. The water supply tube may be connected to an external water supply source. The water supply tube may be extended to a detergent supplier and/or the tub from the external water supply source. Water may be supplied to the tub via the detergent supplier. Water may be supplied to the tub without passing through the detergent supplier.

The water supply valve (not shown) may open or close the water supply tube in response to an electric signal of the processor. The water supply valve may allow or block water supply from the external water supply source to the tub. The water supply valve may include, for example, a solenoid valve that is opened or closed in response to the electric signal.

The washing machine 1 may include the detergent supplier (not shown) arranged to supply a detergent into the tub. The detergent supplier may be arranged to supply the detergent into the tub in the water supply procedure. Water supplied through the supply tube may pass through the detergent supplier and be mixed with the detergent. The water mixed with the detergent may be supplied into the tub. The detergent may include not only laundry detergents but also air fresheners, sterilizers, deodorizers or conditioners for the dryer.

The washing machine 1 may include a drainage system (not shown). The drainage system may be arranged to release the water contained in the tub to the outside. The drainage system may include a drain tube extending from the bottom of the tub to the outside of the housing, and a pump arranged in the drain tube. The pump may pump the water in the drain tube out of the water tub.

A drain hole (not shown) may be formed at the bottom of the tub to drain the water stored in the tub to the outside of the tub. The drain hole may be connected to the drain tube. A drain valve may be arranged at the drain tube to open or close the drain tube.

The controller including the processor may control different kinds of components (e.g., the driving motor and the water supply valve) of the washing machine. The controller may control the different kinds of components of the washing machine to perform at least one course including water supply, washing, rinsing and/or dehydration based on a user input to the input of the user interface panel. For example, the controller may control the driving motor to control rotation speed of the drum or control the water supply valve of the water supplier to supply water into the tub.

The controller may include hardware such as a control processing unit (CPU), a memory, etc., and software such as a control program. For example, the controller may include at least one memory for storing an algorithm to control operations of the components in the washing machine and program codes as data corresponding to the control program, and at least one processor for performing the aforementioned operations with the use of the data stored in the at least one memory. The memory and the processor may be implemented in separate hardware chips or in one integrated chip. The processor may include one, two or more processor chips or one, two or more processing cores. The memory may include one, two or more memory chips or one, two or more memory blocks.

The washing machine 1 of a front-loading type as in FIG. 1A may do the wash by repeating lift and drop of the clothes by rotating the drum 11.

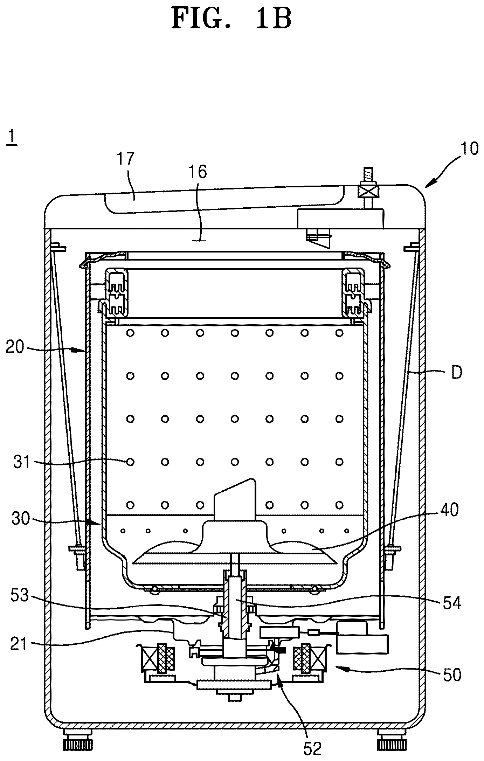

FIG. 1B is a cross-sectional view of a washing machine as a home appliance, according to an embodiment of the disclosure.

In FIG. 1B, the washing machine 1 is a top-loading washing machine having a structure in which the clothes are thrown in from above and drawn out upwardly unlike the front-loading washing machine with a front-facing laundry inlet as shown in FIG. 1A.

As shown in FIG. 1B, the washing machine 1 may include the main body 10 forming an exterior of the washing machine 1, a water tank 20 installed in the main body 10 for receiving water for laundry, a spinning tub 30 rotationally arranged in the water tank 20, a pulsator 40 rotationally arranged on the bottom of the spinning tub 30, and a driver 50 for driving the spinning tub 30 or the pulsator 40.

The main body 10 includes a laundry inlet 16 formed on the top of the main body 10, through which to throw in clothes, and a cover 17 pivotally installed at the main body 10 to open or close the laundry inlet 16.

The water tank 20 constitutes a cylinder with an open top, and is supported by being hung on the main body 10 by several suspensions D coupled to lower outer sides of the water tank 20. The suspensions D may damp vibrations generated by the main body 10 or the water tank 20 during washing or spin-drying.

The spinning tub 30 may constitute a cylinder with an open top, and have a lot of dehydration holes on the circumferential surface to connect the inner space to inner space of the water tank 20.

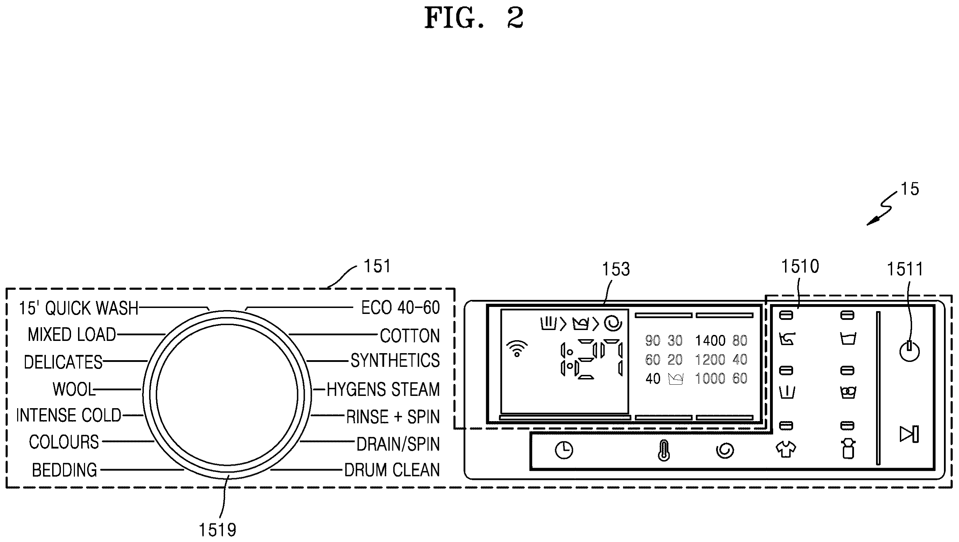

The pulsator 40 may generate a water current during forward rotation or reverse rotation, and the clothes and water in the spinning tub 30 are stirred by the water current. The washing machine 1 of FIG. 2 may wash the clothes by the water current.

The driver 50 may include a driving motor 51 for receiving power and generating driving force, and a power switch 52 for delivering the driving force generated from the driving motor 51 solely to the pulsator 40 or both to the pulsator 40 and the spinning tub 30. A spinning shaft 53 refers to a shaft with cavity coupled to the spinning tub 30, and a laundry shaft 54 is installed in the cavity to penetrate the water tank 20 and the spinning shaft 53 and connect to the pulsator 40.

As shown in FIG. 1A or 1B, the washing machine 1 requires a motor or the driving motor 51 to rotate the drum 11 or the pulsator 40. Hereinafter, the motor or the driving motor 51 for rotating the drum 11 or the pulsator 40 may be collectively referred to as the motor.

In a home appliance such as the washing machine 1, input alternate current (AC) power is rectified and established as a direct current (DC) voltage with the use of a DC link capacitor. The established DC voltage may be converted by an inverter back into an AC voltage. In the home appliance such as the washing machine 1, an intelligent power module (IPM), in which a three-phase inverter and a gate driver are integrated into one, may be used.

FIG. 2 shows a user interface panel of a home appliance, according to an embodiment of the disclosure.

Referring to FIG. 2, shown is the user interface panel 15 of the washing machine 1. The user interface panel 15 may include an input interface 151 for receiving an input or command from the user and an output interface 153 for outputting information to the user. The input interface 151 may include an input module. The output interface 153 may include a display.

The input interface 151 may include an input key region 1510 including a plurality of input keys 1511 that when physically manipulated (e.g., touched or pushed) by the user, sends a corresponding command to the processor of the washing machine 1, and a rotation key 1519 for sending a command from a rotation input of the user to the user interface panel 15.

The plurality of input keys 1511 may include various input keys in the input key region 1510 including a power key, a laundry operation key, etc.

The plurality of input keys 1511 of the input key region 1510 may include a mechanical key and/or an electronic key. Although the user interface panel 15 of FIG. 2 shows the panel used for the washing machine 1, the user interface panel 15 of FIG. 2 may be used for various home appliances. It is obvious that configurations of the input interface 151 and the output interface 153 may vary depending on the home appliances, but the user interface panel 15 usually has the input key region 1510 including at least one input key in common.

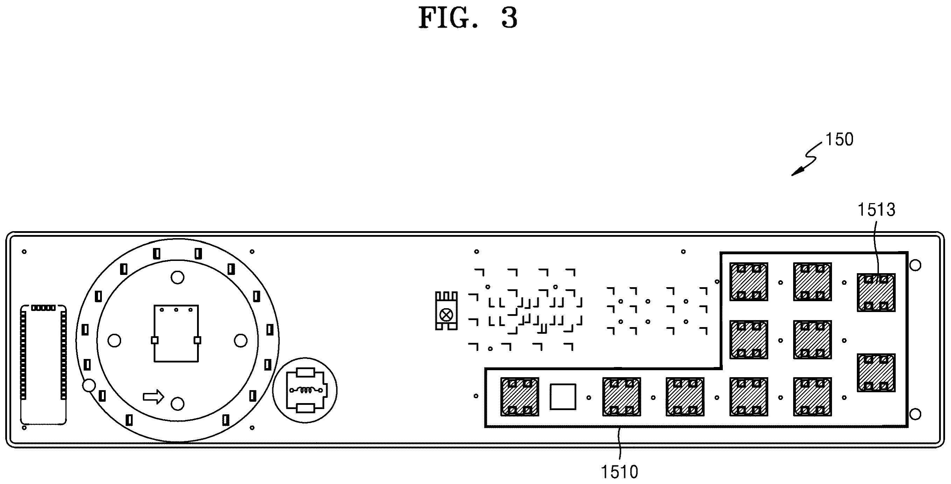

FIG. 3 is a diagram of a PCB of a user interface panel of a home appliance, according to an embodiment of the disclosure.

The PCB is a circuit board on which wires and layout space required to electrically connect between parts are printed Circuits are configured on the PCB through a surface mount technology (SMT) that mounts and solders parts on the surface. In general, different PCBs are designed and used depending on types of input keys mounted thereon. For example, the input key types may include an electronic key (e.g., touch key) type and a mechanical key (tack key) type. The electronic key may include a touch switch. The mechanical key may include a tact switch and/or a tactile switch.

A PCB 150 for the user interface panel of FIG. 3 includes a common mounting region in which the mechanical key and the electronic key may be mounted on the user interface panel 15 of FIG. 2. The input key region 1510 on the PCB 150 for the user interface panel includes a common mounting region 1513 in which the plurality of input keys 1511 may be mounted. In an embodiment of the disclosure, the common mounting region 1513 includes a PCB pattern in which to mount the electronic key or the mechanical key for the user input interface on the PCB 150 for user interface panel.

In an embodiment of the disclosure, the common mounting region 1513 has a plurality of conductive planes exposed for a plurality of terminals of the mechanical key to be soldered. Furthermore, in an embodiment of the disclosure, the common mounting region 1513 includes a conductive plane that may recognize or detect a touch when the electronic key is mounted, and the conductive plane may be coated with immutable ink and not exposed to the outside. The immutable ink may include photo solder resist (PSR) or photoresist.

The mechanical key and the electronic key, which may be input keys of the PCB 150 for user interface panel will now be described. As described in greater detail below, the mechanical key may be responsive to a change in a pressed state, while the electronic key may be responsive to a change in capacitance or resistance.

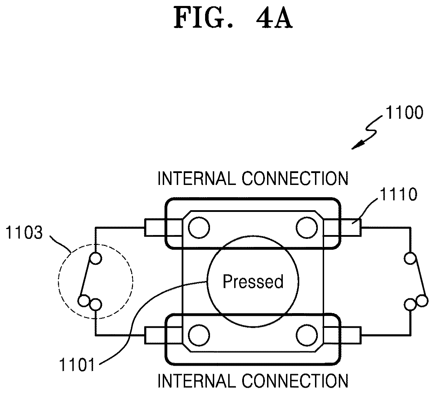

FIG. 4A illustrates a mechanical key as an input key, according to an embodiment of the disclosure.

The mechanical key is a switch made by forming a thin metal plate into a circular or square dome shape, which provides a tactile response (e.g., a clicking sensation) and physically connects two fixed contacts in the switch body when pressed. The mechanical key may include a cover, a plunger, a contact dome, a base, contacts, and a plurality of terminals.

Referring to FIG. 4A, when the user presses a contact dome 1101, which is a thin metal plate on top of the mechanical key 1100, the contact dome 1101 makes contact with a lower contact (not shown) and electrically sends a signal thereto. In FIG. 4A, a switch 1103 is shown as being closed to indicate that a signal is electrically delivered when the user presses the mechanical key 1100.

The mechanical key 1100 may include a plurality of terminals 1110, which may be soldered to the conductive plane on the PCB. Two upper terminals and two lower terminals of the plurality of terminals 1110 are always 'internally connected'. As shown in FIG. 4A, it may be understood that when the user presses the contact dome 1101, the upper and lower terminals of the plurality of terminals 1110 are electrically connected to one another.

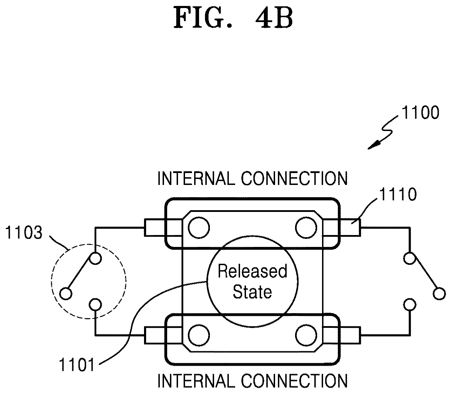

FIG. 4B illustrates a mechanical key as an input key, according to an embodiment of the disclosure.

Unlike FIG. 4A, FIG. 4B shows an occasion when the user takes his/her finger off the mechanical key 110 to release the physically pressed state.

Referring to FIG. 4B, when the user releases the pressed state of the contact dome 1101**,** which is a thin metal plate on top of the mechanical key 1100, the contact dome 1101 no longer makes contact with the lower contact (not shown), and is thus electrically disconnected. In FIG. 4B, a switch 1103 is shown as being opened to indicate that electrical connection is released when the user presses and releases the mechanical key **1100** with his/her finger.

As shown in FIG. 4B, it may be understood that when the user takes his/her finger off the contact dome 1101**,** electric connection between the upper and lower terminals of the plurality of terminals **1110** is released.

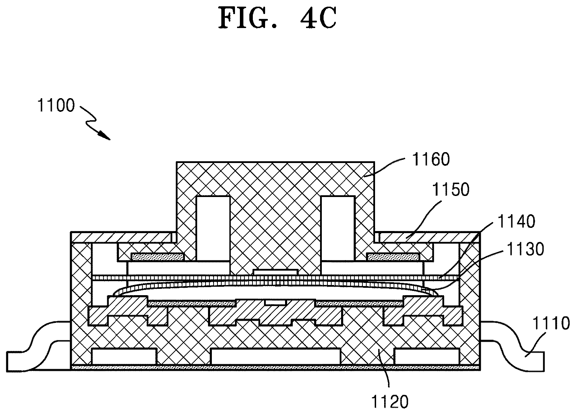

FIG. 4C is a cross-sectional view of a mechanical key as an input key, according to an embodiment of the disclosure.

Referring to FIG. 4C, shown is a cross-sectional view of the mechanical key 1100**.** The mechanical key **1100** may include a main body 1120, the plurality of terminals 1110**,** a contact 1130, a dust cover 1140, a knob 1150 and a cover 1160, but is not limited thereto.

The plurality of terminals **1110** of the mechanical key **1100** are divided by insulation through insert molding from the main body 1120 and soldered for electric connection with the PCB 150 for user interface panel. The plurality of terminals **1110** of the mechanical key **1100** may be classified by the bending shape into U-bending, J-bending, Z-bending, L-bending, gull wing, straight terminals, etc. Although the PCB 150 for user interface panel is referred to as one for user interface panel in an embodiment of the disclosure, the PCB 150 for user interface panel is to be understood as referring to a main printed board assembly (PBA) of a home appliance when the user interface panel is a portion of the PBA. Hereinafter, the PCB 150 for user interface panel may be briefly referred to as a PCB.

The main body 1120 of the mechanical key 1100 is a basic housing equipped with the plurality of terminals 1110 connected to the PCB and fixed contacts. When the main body 1120 is of a surface mount device (SMD) type, it may include an emboss or a pilot pin depending on the model to prevent the mechanical key 1100 from being twisted during PCB mounting.

The contacts 1130 of the mechanical key 1100 may also be referred to as contactors. The contacts 1130 are made by processing a thin metal plate or a carbon film rubber plate, and are parts that make electric contact (connection) through a pressing operation of the user between the fixed contacts of the main body 1120.

The dust cover 1140 of the mechanical key 1100 is also referred to as a film cover, which is a film tape for preventing dust or flux infiltration into the mechanical key 1100**.** The dust cover 1140 is a thin film tape made of polytetrafluoroethylene (PTFE) (e.g., Teflon) or polyester attached on top of the contact 1130 or along edges of the main body 1120.

The knob 1150 of the mechanical key 1100 is also referred to as a stem, which is a molding part to be actually pressed by the user to operate the mechanical key 1100. The knob 1150 may sometimes be omitted depending on the model of the mechanical key 1100.

The cover 1160 of the mechanical key 1100 is a metal or plastic plate located on the top of the main body 1120 to contain the main body 1120 and other parts. The cover 1160 may sometimes be omitted depending on the model of the mechanical key 1100. In an SMD type model of some mechanical keys 1100, a guide pin may sometimes come out from the cover 1160 to pass through the PCB in order to enhance soldering pull and push.

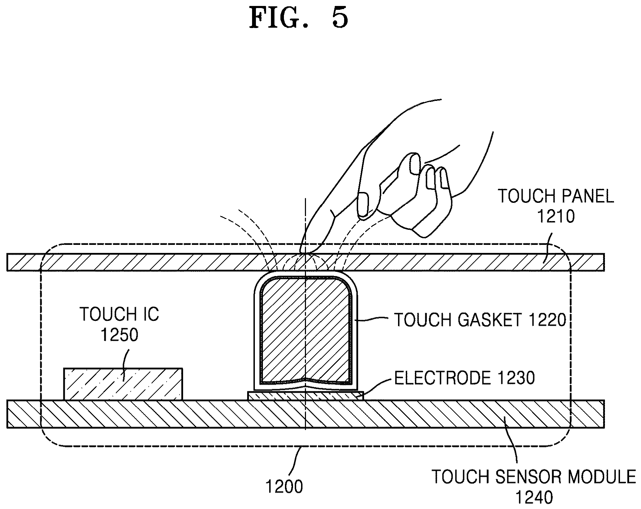

FIG. 5 illustrates an operation of an electronic key, according to an embodiment of the disclosure.

An electronic key 1200 is a key that identifies a 'user's input intent' through a change in capacitance or resistance of a circuit within or connected to the electronic key 1200 in response to the user's touch instead of electric connection made by contact from physical pressure as in the mechanical key 1100. When the dielectric constant of a monopole plate changes by bringing a conductor such as the user's finger close to or in contact with the monopole plate, the electronic key 1200 may detect a corresponding change in capacitance and generate a switching signal based on the result.

The electronic key 1200 may be implemented along with a touch panel 1210, a touch gasket 1220, an electrode 1230 and a touch sensor module 1240 as shown in FIG. 5. In an embodiment of the disclosure, the electronic key 1200 is assumed to include an input key for touch detection, which is mounted in the common mounting region 1500.

The touch panel 1210 may detect the user's touch input and output a touch event value corresponding to the detected touch signal. In a case that the touch panel 1210 and a display panel (not shown) are combined into a touch screen (not shown), the touch screen may be implemented with the touch sensor module 1240 having various types such as capacitive, resistive, piezoelectric, etc. The capacitive type is calculating touch coordinates by using a dielectric coated on the surface of the touch screen to detect micro-electricity caused by the user's body when a portion of the user's body touches the surface of the touch screen. The resistive type is calculating touch coordinates by using two electric plates embedded in the touch screen to detect a flow of current caused by the contact between the upper and lower plates at a touched point when the user touches the screen. A touch event occurring on the touch screen may be generated mainly by a human finger but also by a conductive object that may cause a change in capacitance.

The touch sensed by the touch sensor module 1240 may be processed into data through a touch sensor chip (a touch integrated circuit (IC)) 250. The touch panel 1210 is an interface part on which the user touches in person. When the user's touch is made on the touch panel 1210, the touch gasket 1220 serves as an electrode that connects the touch panel 1210, on which a touch is made in the capacitive input method, to the touch sensor module 1240 or the electrode 1230. In an embodiment of the disclosure, a touch spring or a conductive bar may replace the touch gasket to form the electronic key 1200.

The electrode 1230 also serves to electrically connect the touch gasket 1220 to the touch sensor module 1240. The touch IC 1250 may process data from the touch detected by the touch sensor module 1240. For example, the touch IC 1250 may send the data from the touch detected by the touch sensor module 1240 to the processor 1001 through data communication.

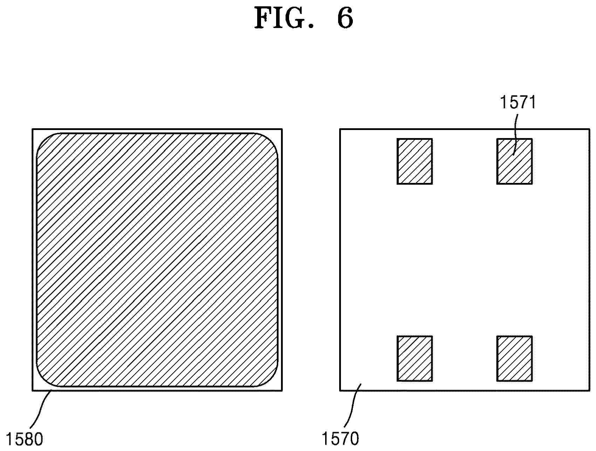

FIG. 6 illustrates a copper foil form of an electronic key and mechanical key mounting region.

Referring to FIG. 6, a left mounting region indicates a PCB pattern for electronic key 1550 and a right mounting region indicates a PCB pattern for mechanical key 1570.

In general, when a PCB is made, the PCB pattern for mechanical key 1570 and the PCB pattern for electronic key 1550 need to be differently provided as shown in FIG. 6. In other words, the PCB pattern for electronic key 1550 on which the electronic key 1200 is mounted and the PCB pattern for mechanical key 1570 on which the mechanical key 1100 is mounted need to be differently designed and made. It is not possible to mount the electronic key on the PCB pattern for mechanical key 1570 and the mechanical key on the PCB pattern for electronic key 1550. The reason is that when the electronic key is mounted on the PCB pattern for mechanical key 1570, the plurality of conductive planes are short-circuited to each other on the PCB pattern for mechanical key 1570, thereby inhibiting the input key function from working properly. Hence, when there are different types of input keys included on the PCB 150 for user interface panel, it leads to inconvenience of having to make different PCB patterns for the different types of input keys.

As for the PCB pattern for electronic key 1550, it is seen that copper foil is etched on the PCB in almost the whole region where the electronic key is mounted. In the PCB pattern for mechanical key 1570, the conductive plane 1571 is included on the PCB to fit the number of terminals of the mechanical key 1100 for the plurality of terminals of the mechanical key 1100 to be soldered. As it is impossible to mix the PCB pattern for electronic key 1550 and the PCB pattern for mechanical key 1570, the designer needs to first determine what type each input key has before making the PCB 150 for user interface panel to design the PCB pattern to fit the determined input key. Hence, once the PCB 150 for user interface panel is made, it is not possible to change the type of the input key from the electronic key 1200 to the mechanical key 1100 or from mechanical key 1100 to the electronic key 1200. Accordingly, there is a need to design a common mounting region allowed for the electronic key 1200 and the mechanical key 1100 to be mounted thereon at any time without predetermining which of the electronic key 1200 and the mechanical key 1100 is to be used as an input key on the PCB 150 for user interface panel.

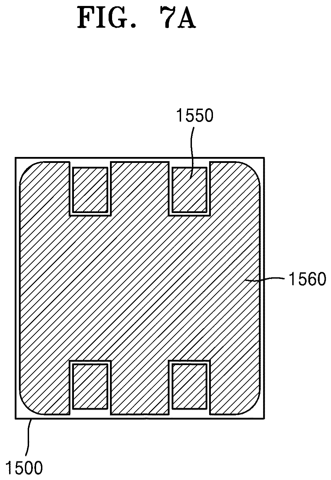

FIG. 7A illustrates a copper foil form of a common mounting region that may be shared by electronic and mechanical keys, according to an embodiment of the disclosure.

In an embodiment of the disclosure, the common mounting region 1500 mounted on the PCB 150 for user interface panel may have a copper foil plane or copper pattern in hatched areas as shown in FIG. 7A. When the copper foil pattern such as the common mounting region 500 of FIG. 7A is used, the manufacturer may first make the PCB 150 for user interface panel, and later determine which of the mechanical key 1100 and the electronic key 1200 is to be used in the common mounting region 1500. In other words, according to an embodiment of the disclosure, it is possible to mount and use any type of input key among the electronic key 1200 and the mechanical key 1100 in the common mounting region 1500.

In an embodiment of the disclosure, the common mounting region 1500 includes the plurality of conductive planes 1550 to which a plurality of terminals of the mechanical key 1100 may be soldered. The plurality of conductive planes 1550 are exposed to the outside for the mechanical key 1100 to be soldered onto the surface of the PCB through the SMT. For convenience of explanation, the plurality of conductive planes 1550 will be referred to as the first conductive plane 1550.

In an embodiment of the disclosure, the plurality of conductive planes 1550 of the common mounting region 1500 are isolated from a conductive plane 1560 other than the plurality of conductive planes 1550 in the common mounting region 1500. For convenience of explanation, the remaining conductive plane 1560 will be referred to as the second conductive plane 1560. In an embodiment of the disclosure, the second conductive plane 1560 other than the first conductive plane 1550 in the common mounting region 1500 is on the same layer with the first conductive plane 1550 and for the electronic key 1200. The second conductive plane 1560, which is a conductive plane for the electronic key 1200, may be used for touch recognition of the touch key, which corresponds to the electronic key 1200. An immutable ink such as photoresist may be applied onto the second conductive plane 1560 other than the first conductive plane 1550 on the PCB used in the home appliance, so that the second conductive plane may not come to the surface.

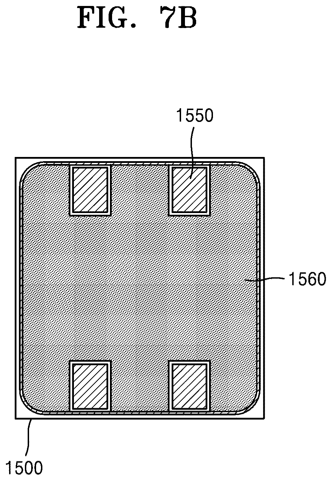

FIG. 7B illustrates a copper foil form that exposes a common mounting region in which both electronic and mechanical keys may be mounted, according to an embodiment of the disclosure.

Referring to FIG. 7B, an immutable ink such as photoresist is applied on the second conductive plane 1560 other than the first conductive plane 1550 in the common mounting region 1500 included on the PCB 150 for user interface panel, so that the copper foil of the second conductive plane 1560 does not come to the surface. Even when the immutable ink is applied onto the second conductive plane 1560 other than the first conductive plane 1550, there is no difficulty in recognizing touch by the touch key.

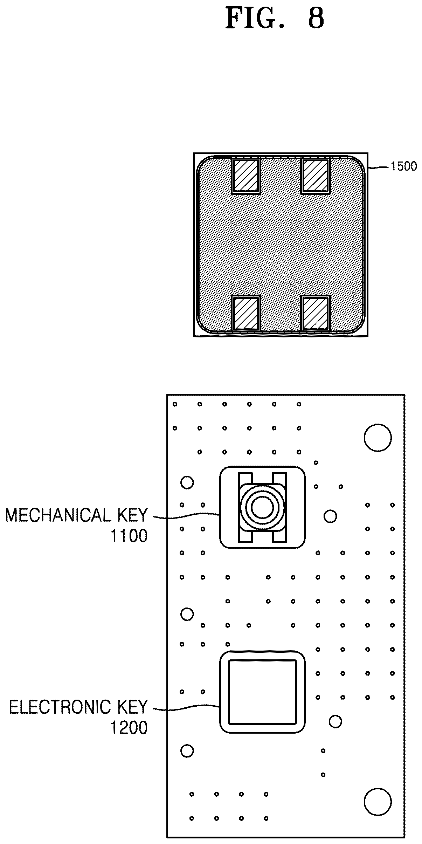

FIG. 8 is a top view of a common mounting region where a mechanical key and an electronic key are mounted, according to an embodiment of the disclosure.

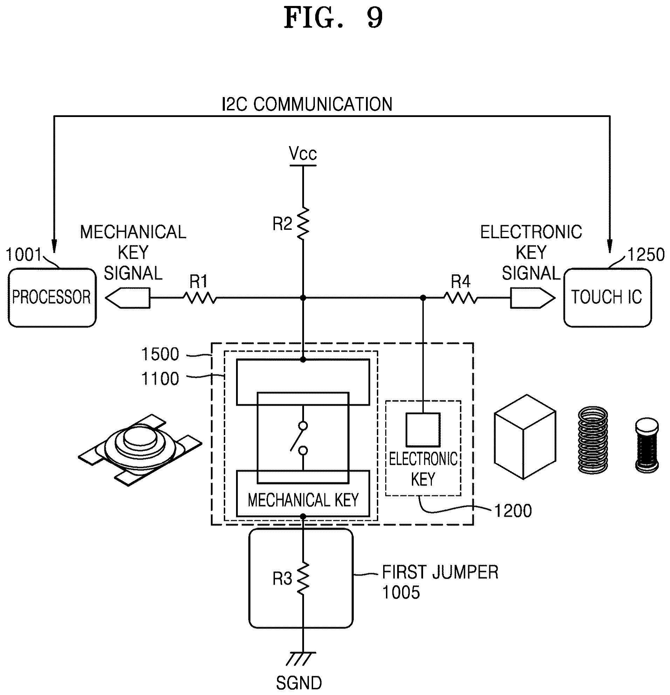

Referring to FIG. 8, it may be seen that the common mounting region 1500 is applied to at least a portion of the PCB 150 for user interface panel, the mechanical key 1100 is mounted in the upper common mounting region and the electronic key 1200 is mounted in the lower common mounting region. As shown in FIG. 9, any input key no matter whether it is the mechanical key 1100 or the electronic key 100 may be mounted in the common mounting region 1500 provided on the PCB.

FIG. 9 is a circuit diagram including a common mounting region, according to an embodiment of the disclosure.

Referring to FIG. 9, shown is a circuit diagram for processing the user's input signal when the mechanical key 1100 or the electronic key 1200 is mounted in the common mounting region 1500. In an embodiment of the disclosure, when the mechanical key 1100 is mounted in the common mounting region 1500, a first jumper 1005 is connected to a ground reference (SGND) via a resistor (e.g., R3) of 0 ohm.

Jumpers (also referred to as jumper connectors), including the first jumper 1005, are components of the circuit connected to parts to form a circuit to help the circuit operate. In the disclosure, a jumper may include a path in the circuit that electrically connects or disconnects between both ends of the circuit, and the electrical connection between both ends of the circuit may be made through a resistor, a jumper connector or soldering.

As the electrical connection may be made with the 0 ohm resistor (e.g., R3) provided on the first jumper 1005, the first jumper 1005 may be referred to as a 0 ohm jumper. When the mechanical key 1100 is pressed by the user, contacts in the mechanical key 1100 are connected, and at the same time a low signal is transmitted to the processor 1001 as a mechanical key signal. In an embodiment of the disclosure, such a signal input from the mechanical key 1100 may be processed oppositely, i.e., a high signal may be transmitted to the processor 1001 when the internal contacts are connected.

In an embodiment of the disclosure, when the electronic key 1200 is mounted in the common mounting region 1500 and the user touches the electronic key 1200, the touch is transmitted to the touch IC 1250 in an electronic key signal and the touch IC 1250 processes the electronic key signal as touch data. The touch data processed by the touch IC 1250 may be transmitted to the processor 1001 from the touch IC 1250 through communication. In an embodiment of the disclosure, for the communication, inter-integrated circuit (I2C) communication may be non-exclusively used, and other types of communication may also be used. When the electronic key 1200 is mounted in the common mounting region 1500, the electronic key 1200 may contact the first conductive plane 1550 provided for the electronic key 1200 to connect to the plurality of terminals of the mechanical key 1100, so the resistor of 0 ohm is removed from the first jumper 1005 to avoid connection to the ground SGND. However, the opening of the first jumper (by removing the 0 ohm resistor) is applied when the electric key 1200 has a size to contact the plurality of conductive planes 1550 provided for the mechanical key 1100 in the common mounting region 1500. In other words, when the size (cross-sectional area) of the electronic key 1200 is small enough for the bottom portion of the electronic key 1200 not to contact the first conductive plane 1550 provided for the mechanical key 1100, it does not matter when the first jumper 1005 is short-circuited.

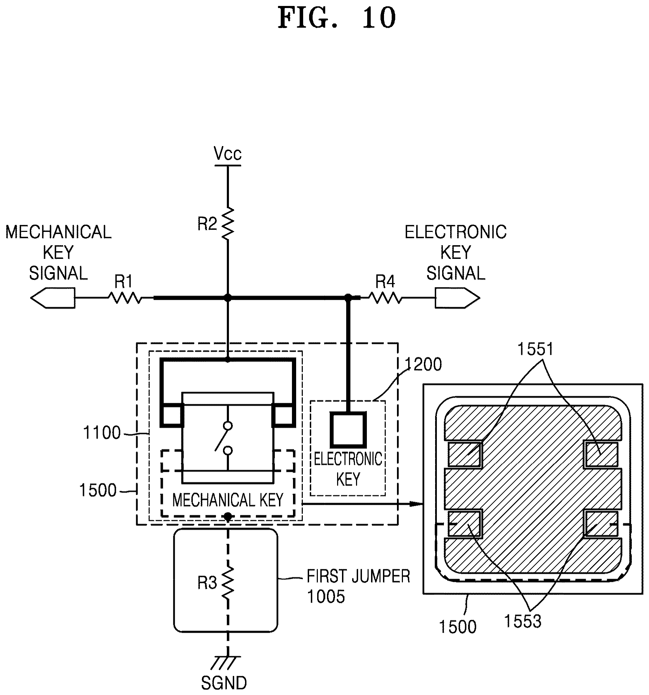

FIG. 10 is circuit diagram including a common mounting region, according to an embodiment of the disclosure.

In FIG. 10, it is seen that the upper conductive planes 1551 and the lower conductive planes 1553 among the plurality of conductive planes 1550 included in the mechanical key 1100 are electrically separated. When the user presses the mechanical key 1100, the upper conductive plane 1551 and the lower conductive plane 1553 are electrically connected to each other. It is seen that the lower conductive planes 1553 among the plurality of conductive planes 1550 are connected to the ground SGND through the first jumper 1005.

In an embodiment of the disclosure, the electronic key 1200 may be electrically connected to the upper conductive planes 1551 of the first conductive plane 1550. Hence, the first jumper 1005 may be opened to prevent the electronic key 1200 from connecting to the ground SGND when actually mounted on the PCB and coming into contact with the lower conductive plane 1553. However, this may happen on the assumption that the electronic key 1200 touches the lower conductive plane 1553 of the first conductive plane 1550. When the size (cross-sectional area) of the electronic key 1200 is small enough for the electronic key 1200 not to come into contact with the lower conductive plane 1553 of the first conductive plane 1550, there is no need to open the first jumper 1005 but maintain it in the short-circuited state.

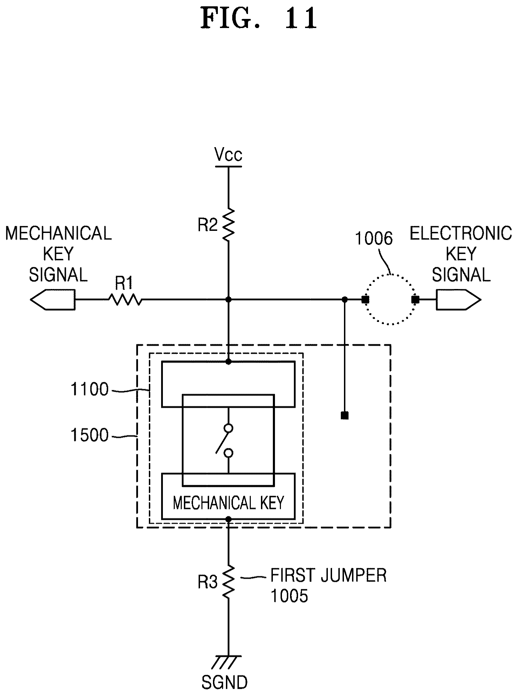

FIG. 11 is a circuit diagram of a case that a mechanical key is mounted in a common mounting area, according to an embodiment of the disclosure.

In FIG. 11, shown is a circuit diagram of a case that the mechanical key 1100 is mounted in the common mounting region 1500. When the mechanical key 1100 is mounted in the common mounting region 1500, the first jumper 1005 is short-circuited for the ground and the mechanical key 1100 to be electrically connected to each other. In an embodiment of the disclosure, when the mechanical key 1100 is mounted in the common mounting region 1500, connection between the mechanical key 1100 and the touch IC 1250 may be opened by a second jumper 1006 to prevent data from being input to the touch IC 1250.

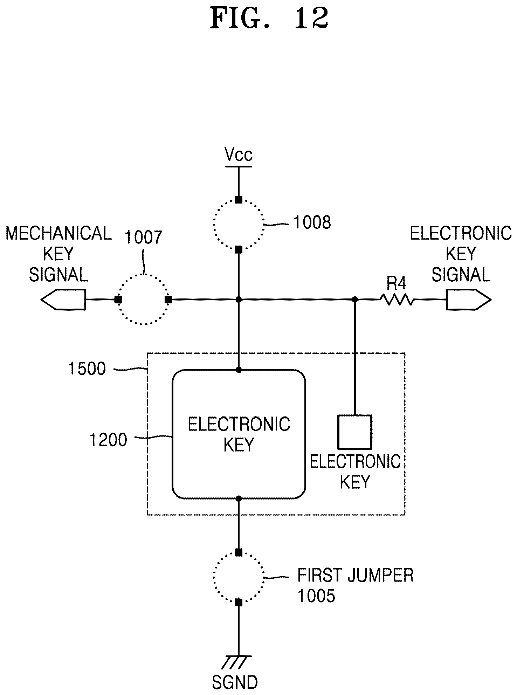

FIG. 12 is a circuit diagram of a case that an electronic key is mounted in a common mounting region, according to an embodiment of the disclosure.

In FIG. 12, shown is a circuit diagram of a case that the electronic key 1200 is mounted in the common mounting region 1500. When the electronic key 1200 is mounted in the common mounting region 1500, the first jumper 1005 is opened for the electronic key 1200 and the ground to be electrically disconnected from each other. As described above, it is obvious that the first jumper 1005 does not need to be opened when the electronic key 1200 has a cross-sectional area that does not come into contact with the first conductive plane 1550 of the common mounting region 1500. In an embodiment of the disclosure, when the electronic key 1200 is mounted in the common mounting region 1500, connection between the electronic key 1200 and the processor 1001 may be opened by a third jumper 1007 to prevent data transmission to the processor 1001. Furthermore, as connection to a power source Vcc is required for operation of the mechanical key 1100, a fourth jumper 1008 may be opened to even disconnect the electronic key 1200 from the power source Vcc.

When a touch gasket is mounted as the electronic key 1200 in the common mounting region 1500, a double-sided tape may be attached to the touch gasket to be mounted in the common mounting region 1500.

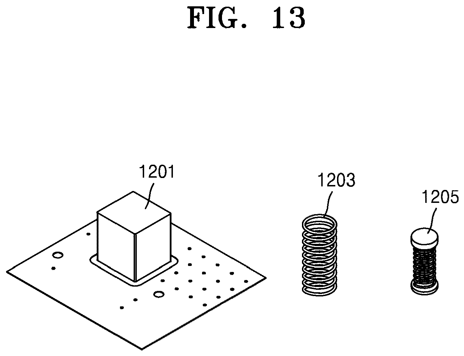

FIG. 13 is a diagram illustrating types of electronic keys, according to an embodiment of the disclosure.

When the user's touch is made on the touch panel 1210, which is an interface portion to be directly touched by the user, the touch gasket 1220 serves as an electrode that connects the touch panel 1210, on which a touch is made in the capacitive input method, to the touch sensor module 1240 or the electrode 1230. In an embodiment of the disclosure, to make up the electronic key 1200, a touch spring 1203 or a steel bar 1205 may be used instead of the touch gasket 1201, as shown in FIG. 13.

In an embodiment of the disclosure, the touch gasket 1201, the touch spring 1203 and the steel bar 1205 may all serve to deliver the user's touch to the common mounting region 1500 on the PCB used for the user interface panel.

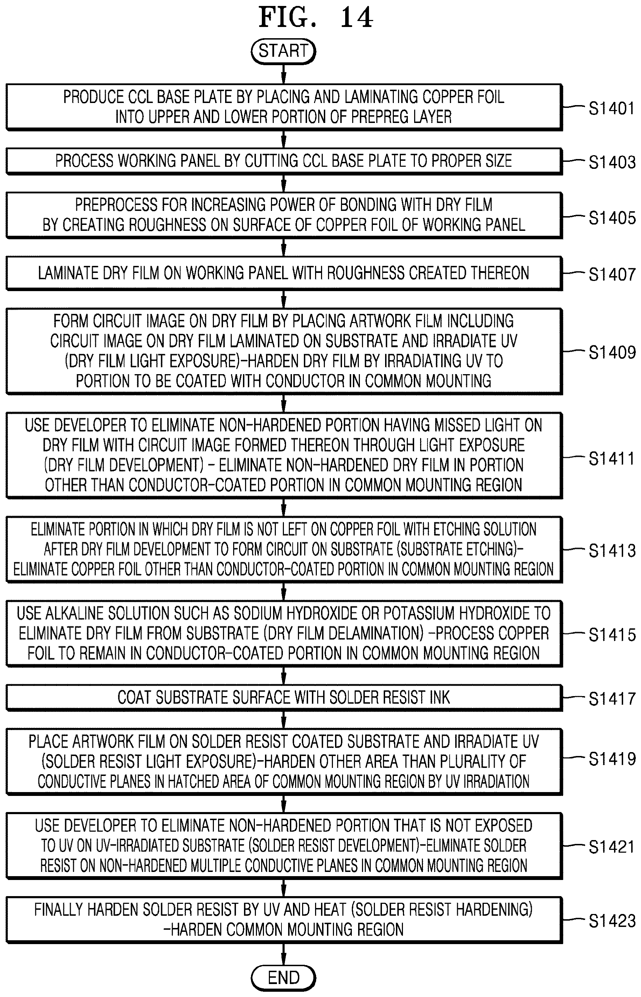

FIG. 14 is a flowchart of a process of producing a PCB that includes a common mounting region, according to an embodiment of the disclosure.

A process of manufacturing a PCB used for a user interface panel to include the common mounting region 1500 according to an embodiment of the disclosure will now be described.

In operation S1401, a copper clad laminate (CCL) base plate is produced. The CCL base plate is made by lamination of glass fiber with copper foil placed on the top and bottom of prepregs containing epoxy or phenol resin. A prepreg layer or "also referred to as a "prepreg" is an intermediate substrate for fiber-reinforced composite materials, and is a molding material in which glass (reinforced) fibers are pre-impregnated with a matrix resin such as epoxy or phenol resin.

In operation S1403, a working panel is processed. The CCL base plate as made previously may be cut to a proper size fit for process equipment. The CCL base plate cut to the proper size may be referred to as a working panel.

Operation S1405 is a preprocessing operation. The preprocessing operation is a process to increase power of bonding with a dry film by creating roughness on the copper foil surface of the previously produced working panel. In addition, reference holes used in laminating the working panel may be processed. The dry film is a coating agent with a photosensitive film specially designed for manufacturing the PCB or other chemically treated parts laminated thereon, and is a material that may withstand various electroplating solutions or corrosive solutions. The dry film may include photoresist. In an embodiment of the disclosure, the dry film is required for circuit protection during panel etching.

Operation S1407 is a dry film lamination operation including a process of laminating the dry film on the working panel with roughness created thereon. The working panel with the dry film laminated thereon may be referred to as a substrate or a PCB substrate.

Operation S1409 is a dry film exposure operation, which is a process of forming a circuit image on the dry film by placing an artwork film including the circuit image on the dry film laminated on the substrate and irradiating ultraviolet (UV) rays thereto. In an embodiment of the disclosure, the artwork film may include a circuit including the common mounting region 1500. In an embodiment of the disclosure, the artwork film may include the circuit as shown in FIGS. 9, 10, 11 and 12, which includes the common mounting region 1500. In an embodiment of the disclosure, the dry film exposure operation includes hardening the dry film by irradiating UV rays into a hatched portion of the common mounting region 1500 shown in FIG. 7A.

Operation S1411 is a dry film development operation, which is a process of using a developer to eliminate non-hardened portion that has missed the light on the dry film on which the circuit image is formed by light exposure. In an embodiment of the disclosure, the dry film development operation includes eliminating the non-hardened dry film in a portion other than the hatched portion of the common mounting region 1500 shown in FIG. 7A.

Operation S1413 is a substrate etching operation. It is a process of eliminating a portion with etching fluids, in which no dry film is left on the copper foil after the dry film development to form a circuit on the substrate. In an embodiment of the disclosure, the dry film etching operation includes eliminating the copper foil in the portion other than the hatched portion of the common mounting region 1500 shown in FIG. 7A.

Operation S1415 is a dry film delamination operation. It is a process of eliminating the dry film that acted as a protective film during etching in the previous etching operation by using an alkaline solution such as sodium hydroxide or potassium hydroxide. In an embodiment of the disclosure, the dry film delamination operation includes processing the copper foil to remain only in the hatched portion of the common mounting region 1500 by eliminating the dry film left in the hatched portion of the common mounting region 1500 shown in FIG. 7A.

Operation S1417 is a solder resist dry operation, which is a process of coating the substrate surface (including the common mounting region 1500), on which the dry film delamination operation has been completed, with the solder resist ink. The solder resist may serve to protect substrate surface circuits by preventing oxidation, maintain electrical isolation stability by preventing short circuits between the substrate surface circuits and prevent solder (lead) adhesion to a portion other than the parts mounted on the substrate surface. The solder resist dry operation includes volatilizing solvent components in the solder resist and drying the solder resist at a temperature of about 80 degrees Celsius.

Operation S1419 is a solder resist exposure operation. The solder resist exposure operation includes a procedure for placing an artwork film on the solder resist coated substrate and irradiating UV on it. In an embodiment of the disclosure, the solder resist exposure operation includes hardening the second conductive plane 156 other than the first conductive plane 1550 among the hatched portion of the common mounting region 1500 shown in FIG. 7A.

Operation S1421 is a solder resist development operation. The solder resist development operation includes a procedure for eliminating a non-hardened portion that is not exposed to the UV on the UV-irradiated substrate by using a developer. In an embodiment of the disclosure, the solder resist development operation includes eliminating the non-hardened solder resist of the first conductive plane 1550 among the hatched portion of the common mounting region 1500 shown in FIG. 7A.

Operation S1423 is a solder resist hardening operation. The solder resist hardening operation includes finally hardening the solder resist by UV and heat. In an embodiment of the disclosure, the solder resist development operation includes finally hardening the common mounting region 1500 shown in FIG. 7A.

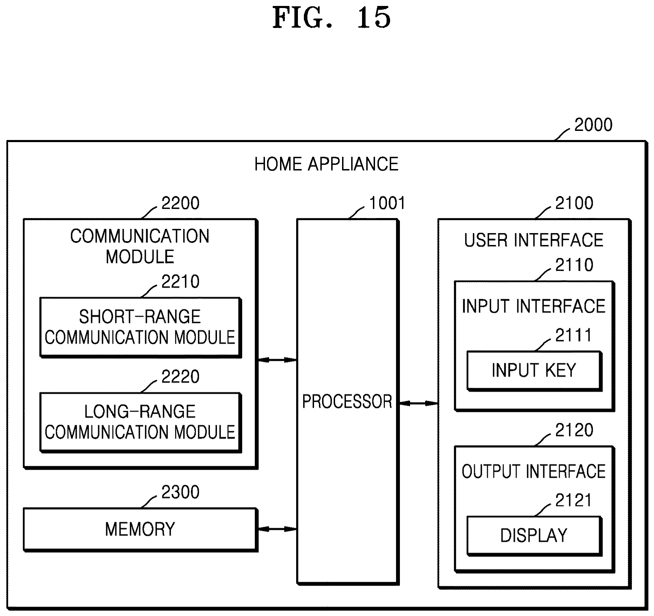

FIG. 15 is a block diagram of a home appliance, according to an embodiment of the disclosure.

In an embodiment of the disclosure, a home appliance 2000 of FIG. 15 may include the processor 1001, a user interface 2100, a communication module 2200, and a memory 2300. In an embodiment of the disclosure, the home appliance 2000 of FIG. 15 may further include a motor (not shown), an inverter circuit (not shown) for driving the motor, and a switching mode power supply (SMPS) (not shown) for supplying power to a PBA including the inverter circuit and the processor 1001, depending on the function required by the home appliance 2000.

The processor 1001 is a hardware device for controlling general operation of the home appliance 2000. The processor 1001 may include one or more processors. In an embodiment of the disclosure, the processor 1001 may be a hardware processing circuit including at least one of a central processing unit (CPU), a graphics processing unit (GPU), an accelerated processing unit (APU), a many integrated core (MIC), a digital signal processor (DSP) or a neural processing unit (NPU). The processor 1001 may be implemented in the form of a system on chip (SoC) with one or more electronic components integrated therein. When the processor 1001 includes multiple processors, each processor may be implemented in separate hardware (H/W). The processor 1001 may also be referred to as a microprocessor controller (MICOM), a microprocessor unit (MPU), or a micro controller unit (MCU). **In** the disclosure, the processor 1001 is a hardware device that may be implemented with a single core processor or a multi-core processor.

The home appliance 2000 may optionally include the communication module 2200 for performing communication internally or with external devices. For example, the home appliance 2000 may communicate with an external server (not shown) and/or user equipment (not shown) through the communication module 2200. In this case, the communication module 2200 may communicate with the server in a first communication scheme (e.g., Wi-Fi communication scheme) and with the user equipment in a second communication scheme (e.g., bluetooth low energy (BLE) communication scheme).

The communication module 2200 may include a short-range wireless communication interface 2210, a long-range wireless communication interface 2220, etc. The short-range communication module 2210 may include a bluetooth communication module, a BLE communication module, a near field communication (NFC) module, a wireless local area network (WLAN), e.g., Wi-Fi, communication module, a Zigbee communication module, an infrared data association (IrDA) communication module, a Wi-Fi direct (WFD) communication module, a ultra wideband (UWB) communication module, an Ant+ communication module, etc., without being limited thereto. The long-range communication module 2220 may be used for the home appliance 2000 to remotely communicate with the server or user equipment. The long-range communication module 2220 may include the Internet, a computer network (e.g., a local area network (LAN) or wide area network (WAN)), or a mobile communication module. The mobile communication module may include a 3rd generation (3G) module, a 4th generation (4G) module, a 5th generation (5G) module, a long term evolution (LTE) module, a narrow band (NB) Internet of things (IoT) module, an LTE machine type communication (LTE-M), etc., without being limited thereto.

The communication module 2200 may transmit data to the processor 1001 through, for example, asynchronous communication, i.e., a universal asynchronous receiver/transmitter (UART) protocol, but the communication scheme is not limited thereto.

The user interface 2100 of the home appliance 2000 may be implemented on the PCB 150 for user interface panel, according to an embodiment of the disclosure. The user interface 2100 may include an output interface 2120 and an input interface 2110. The input interface 2110 may be a channel that allows the user to input a command to the home appliance 2000. The input interface 2110 may include a touch screen, voice input, physical buttons, etc., without being limited thereto. The input interface 2110 may include a laundry start button, a dry start button, a mode selection button, etc. The laundry start button, the dry start button, the mode selection button, etc., may be implemented by input keys 2111, and the input keys 2111 may include the mechanical key 1100 and/or the electronic key 1200. The PCB used for the user interface panel 15 on which the user interface 2100 is implemented may include the common mounting region 1500 in which any of the mechanical key 1100 and the electronic key 1200 may be mounted.

The output interface 2120 may include a display 2121 such as an LED, an LCD, a touch screen, etc. The output interface 2120 may further include a voice output device, without being limited thereto. The output interface 2120 may display software update progress information, operation event information, overheat information, information about a heated point, etc., without being limited thereto.

The memory 2300 of the home appliance 2000 may store a program (e.g., one or more instructions) for the processor 1001 to control general operation of the home appliance 2000 and input/output data. For example, the memory 2300 of the home appliance 2000 may store data or programs such as software related to controlling the home appliance 2000, heated status data, error occurrence data (fault history data), operation event types, etc., without being limited thereto. The memory 2300 of the home appliance 2000 may store data received from external user equipment.

The memory 2300 may include at least one type of storage medium including a flash memory, a hard disk, a multimedia card micro type memory, a card type memory (e.g., SD or XD memory), a random access memory (RAM), a static random access memory (SRAM), a read-only memory (ROM), an electrically erasable programmable read-only memory (EEPROM), a programmable ROM (PROM), a magnetic memory, a magnetic disk, and an optical disk. The programs stored in the memory 2300 may be classified into multiple modules on the function basis.

In an embodiment of the disclosure, the home appliance 2000 may include not only the washing machine 1 but also many different home appliances. In an embodiment of the disclosure, the home appliance 2000 may include an electric oven, an air conditioner, a vacuum cleaner, a refrigerator, an electric rice cooker, a television (TV), an induction cooker, etc.

However, not all the components illustrated in FIG. 15 are essential. The home appliance 2000 may be implemented with more or fewer components than illustrated in FIG. 15.

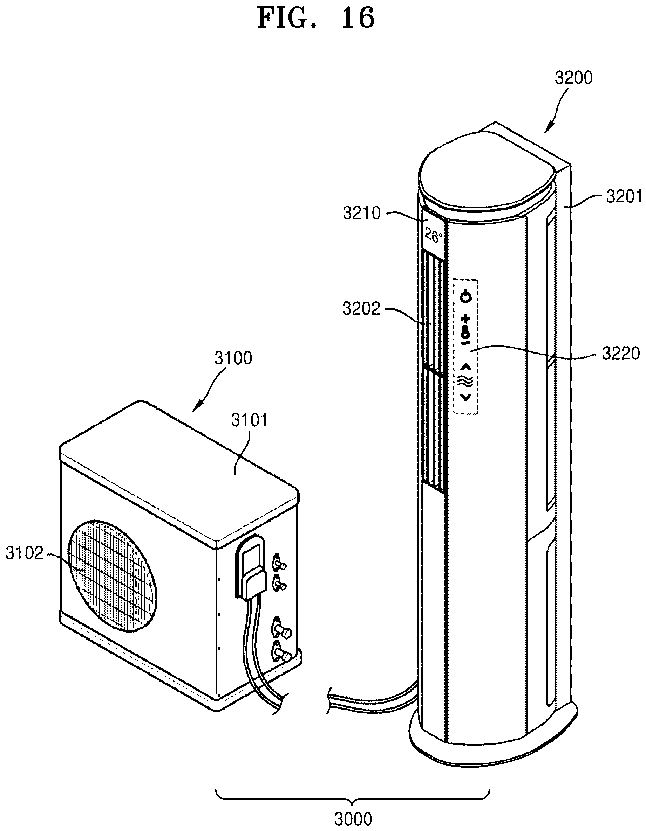

FIG. 16 is a perspective view of an air conditioner among home appliances, according to an embodiment of the disclosure.

In an embodiment of the disclosure, an air conditioner 3000 may absorb heat from an air conditioning space (hereinafter, referred to as indoor space) and release the heat to the outside (hereinafter, referred to as outdoor space) of the indoor space to cool the indoor space for air conditioning. Furthermore, the air conditioner 3000 may absorb heat from the outdoor space and release the heat into the indoor space to heat the indoor space.

The air conditioner 3000 may include one or more outdoor unit 3100 installed outdoors and one or more indoor unit 3200 installed indoors. The outdoor unit 3100 may be electrically connected to the indoor unit 3200. For example, the user may input information (or commands) to control the indoor unit 3200 through a user interface panel 3220, and the outdoor unit 3100 may operate in response to the user input for the indoor unit 3200.

The outdoor unit 3100 may be fluidly connected to the indoor unit 3200 through a refrigerant tube.

The outdoor unit 3100 is placed outdoors. The outdoor unit 3100 may perform heat exchange between the refrigerant and outdoor air by using a phase change of the refrigerant (e.g., evaporation or condensation). In this case, the heat exchange may be performed by an outdoor heat exchanger included in the outdoor unit 3100. For example, the refrigerant may release heat through the outside air while the refrigerant is being condensed. The refrigerant may absorb heat from the outside air while the refrigerant is being evaporated.

The indoor unit 3200 is placed indoors. The indoor unit 3200 may perform heat exchange between the refrigerant and indoor air by using a phase change of the refrigerant (e.g., evaporation or condensation). In this case, the heat exchange may be performed by an indoor heat exchanger included in the indoor unit 3200. For example, the refrigerant may absorb heat from the indoor air while the refrigerant is being evaporated, so that the indoor space may be cooled. The refrigerant may release heat through the indoor air while the refrigerant is being condensed, so that the indoor space may be heated. The air conditioner 3000 may include a compressor, an outdoor heat exchanger, an expansion device, and an indoor heat exchanger. The air conditioner 3000 may include a refrigerant tube that connects between the compressor, the outdoor heat exchanger, the expansion device, and the indoor heat exchanger.

The indoor unit 3200 of the air conditioner 3000 may include the user interface panel 3220 that may display operation information of the air conditioner 3000 and receive a command from the user. A display of the user interface panel 3220 may receive information about an operation of the air conditioner 3000 from a processor that controls the operation of the air conditioner 3000 and display information corresponding to the received information. The display may include an indicator for indicating an operation type of the air conditioner 3000 selected by the user or whether the indoor unit 3200 is powered on or off. The indicator may include, for example, an LCD panel, an LED panel, or a plurality of LEDs.

The outdoor unit 3100 includes an outdoor unit body 3101 that forms an exterior of the outdoor unit 3100, and an outdoor unit fan 3102 arranged on one side of the outdoor unit body 3101 for discharging heat-exchanged air.

The indoor unit 3200 may include an indoor unit body 3201 that forms an exterior of the indoor unit 3200, an indoor unit outlet 3202 arranged on the front of the indoor unit body 3201 for discharging heat-exchanged air, and a user interface panel 3220 for receiving an operation command for the air conditioner 3000 from the user.

The user interface panel 3220 of FIG. 16 may use the PCB 150 for user interface panel according to an embodiment of the disclosure, and the PCB 150 for user interface panel may include the common mounting region 1500 where the mechanical key 1100 and the electronic key 1200 may be mounted.

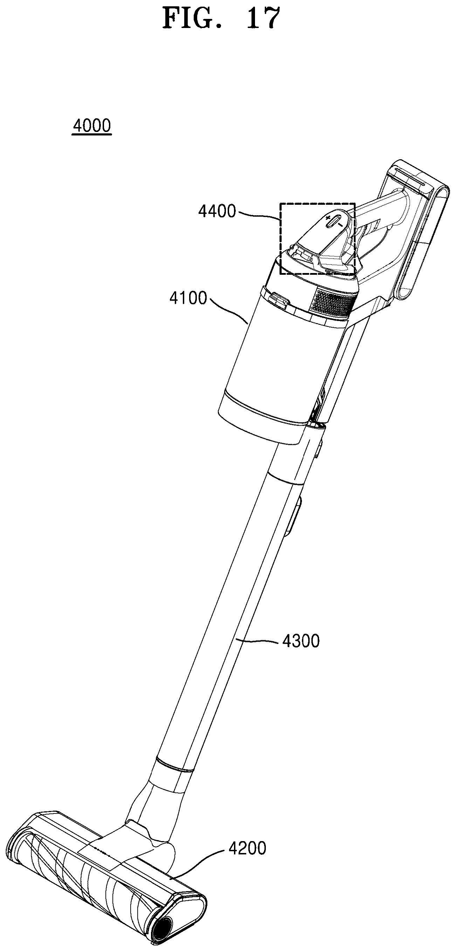

FIG. 17 illustrates a cleaner among home appliances, according to an embodiment of the disclosure.

Referring to FIG. 17, the home appliance 2000 according to an embodiment of the disclosure may include a cleaner 4000. The cleaner 4000 may include a wireless cleaner having a rechargeable battery built therein and having no need for connecting a power cord to an outlet for cleaning. In an embodiment of the disclosure, the cleaner 4000 may include a wired vacuum cleaner used for cleaning while connecting the power cord to the outlet. For convenience of explanation, descriptions will be focused on the wireless cleaner in FIG. 17. The user may use a handle equipped on the main body of the cleaner 4000 to move the cleaner 4000 forward and backward for a brush device (a cleaner head) to be able to suck up dust or debris from the floor to be cleaned.

Referring to FIG. 17, the cleaner 4000 may be a stick-type cleaner including a cleaner body 4100, a brush device 4200 and an extension tube 4300. However, not all the components illustrated in FIG. 17 are essential. The cleaner 4000 may be implemented with more or fewer components than illustrated in FIG. 14. For example, the cleaner 4000 may be implemented with the cleaner body 4100 and the brush device 4200 but the extension tube 4300. Furthermore, the cleaner 4000 may further include a station (not shown) for battery charging and dust discharging from the cleaner body 4100.

A suction motor 4500 included in the cleaner body 4100 of the cleaner 4000 performs an operation of sucking up dust during cleaning.

The cleaner 4000 may include a user interface panel 4400. The user interface panel 4400 may allow the user to selectively input a cleaning intensity during the cleaning, and display a charging state or cleaning mode through a display included in the user interface panel 4400.

The user interface panel 4400 of FIG. 17 may use the PCB 150 for user interface panel according to an embodiment of the disclosure, and the PCB 150 for user interface panel may include the common mounting region 1500 where the mechanical key 1100 and the electronic key 1200 may be mounted.

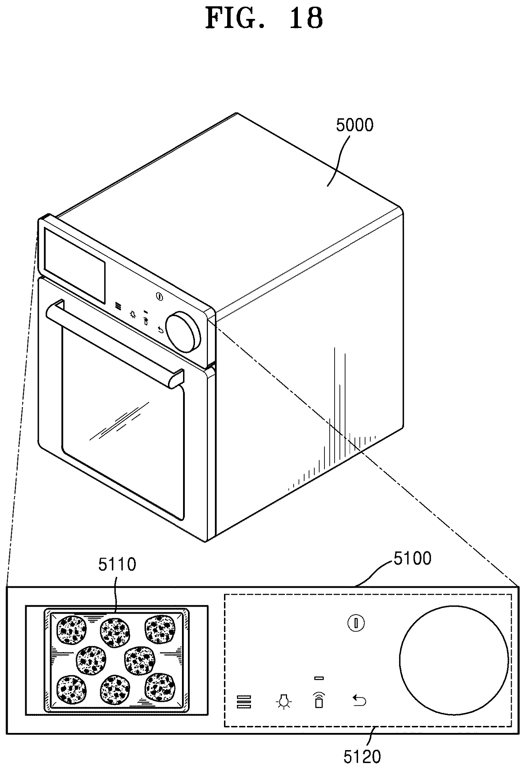

FIG. 18 is a perspective view of an electronic oven among home appliances, according to an embodiment of the disclosure.

The home appliance 2000 that employs a user interface panel including the common mounting region 1500 according to the disclosure may not be limited to the washing machine 1 but may be applied to various home appliances.

As the home appliance 2000 according to an embodiment of the disclosure, an electric oven 5000 may include a user interface panel 5100. The user interface panel 5100 may include a display as an output interface 5110 that may show an internal state on the outside, and an input interface 5120 that may send the user's command to the electric oven 5000. For example, the home appliance 2000 of FIG. 18 may be not only the electric oven but also a dish washer, a small refrigerator, etc. The small refrigerator may include, for example, a cosmetic refrigerator, a wine refrigerator (also referred to as a wine cellar, a CAVE, a cabinet cellar, a wine cooler, or the like), etc. When the home appliance 2000 of FIG. 18 is an oven, the internal space may be expressed as a cooking room; when the home appliance 2000 of FIG. 18 is a small refrigerator, the internal space may be expressed as a storage room; when the home appliance 2000 of FIG. 18 is a dish washer, the internal space may be expressed as a container.

The user interface panel 5100 of FIG. 18 may use the PCB 150 for user interface panel according to an embodiment of the disclosure, and the PCB 150 for user interface panel may include the common mounting region 1500 where the mechanical key 1100 and the electronic key 1200 may be mounted.

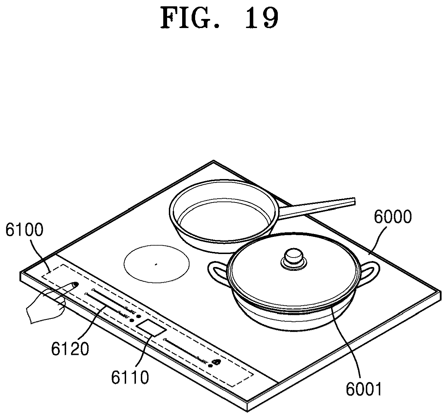

FIG. 19 shows an induction device, according to an embodiment of the disclosure.

Referring to FIG. 19, the home appliance 2000 according to an embodiment of the disclosure may be established as an induction device 6000, which may also be referred to as an induction heater or an induction cooker.

In an embodiment of the disclosure, the induction device 6000 may be a device that transmits wireless power to an object to be heated (e.g., a cooking container 6001) located on the top by electromagnetic induction. The induction device 6000 may include a working coil that generates a magnetic field to inductively heat the cooking container 6001.

That the working coil generates the magnetic field may refer to transmitting power by using a magnetic field induced to induction heating (IH) metal (e.g., iron) by magnetic induction. For example, the induction device 6000 may have a current flow to the working coil to produce a magnetic field, thereby generating an eddy current on the cooking container 6001.

In an embodiment of the disclosure, the induction device 6000 may display information relating to the cooking container 6001 through a user interface panel 6100. For example, the induction device 6000 may display identification information of the cooking container 6001 and location information of the cooking container 6001 on an output interface 6110 included in the user interface panel 6100 when the cooking container 6001 is detected. Furthermore, the induction device 6000 may send a user command to a processor of the induction device 6000 through an input interface 6120 included in the user interface panel 6100.

The user interface panel 6100 of FIG. 19 may use the PCB 150 for user interface panel according to an embodiment of the disclosure, and the PCB 150 for user interface panel may include the common mounting region 1500 where the mechanical key 1100 and the electronic key 1200 may be mounted.

FIGS. 16 to 19 illustrate the user interface panel including the common mounting region 1500 according to an embodiment of the disclosure, but the home appliance 2000 according to the disclosure is not limited thereto and may be applied any home appliances including the user interface panel.

According to an embodiment of the disclosure, a washing machine including a common mounting region allowed for a mechanical key and an electronic key to be mounted thereon includes a door through which laundry is thrown in or drawn out, a drum receiving the laundry, a motor rotating the drum for doing the wash, a user interface panel providing information relating to washing of the laundry and receiving a user input, a processor configured to drive the motor or control the motor to do the wash based on the user input, and a PCB used for the user interface panel. In an embodiment of the disclosure, the washing machine may include a common mounting region where an electronic key or a mechanical key for input interface is allowed to be mounted. In an embodiment of the disclosure, the washing machine may include a first jumper connecting the common mounting region to ground. In an embodiment of the disclosure, the washing machine may include a plurality of conductive planes to be coupled to terminals of the mechanical key.

In an embodiment of the disclosure, when the mechanical key is mounted in the common mounting region, the first jumper may be short-circuited.

In an embodiment of the disclosure, when the electronic key is mounted in the common mounting region, the first jumper may be opened.

In an embodiment of the disclosure, when the electronic key is mounted in the common mounting region without contacting the plurality of conductive planes, the first jumper may be opened or short-circuited.

In an embodiment of the disclosure, the common mounting region may include a copper foil plane electrically connected to the electronic key, which is isolated from the plurality of conductive planes connected to the mechanical key.

In an embodiment of the disclosure, the copper foil plane electrically connected to the electronic key and the plurality of conductive planes connected to the mechanical key may form the same layer.

In an embodiment of the disclosure, the plurality of conductive planes connected to the mechanical key may be electrically connected to a plurality of terminals of the mechanical key when the mechanical key is mounted on the PCB.

In an embodiment of the disclosure, the copper foil plane connected to the electronic key may be a remaining conductive plane other than the plurality of conductive planes connected to the plurality of terminals of the mechanical key.

In an embodiment of the disclosure, the copper foil plane connected to the electronic key may be coated with immutable ink and processed not to be exposed to the outside.

In an embodiment of the disclosure, the electronic key may include a touch key for generating a signal in response to a touch of the user.

In an embodiment of the disclosure, the touch key may include at least one of a touch gasket, a touch spring or a conductor bar as an electrode to connect a touch panel on which touch is made in a touch input scheme to the PCB used for the user interface panel.

In an embodiment of the disclosure, the washing machine may further include a touch IC configured to detect a touch, and the touch IC may detect a signal generated according to the user's touch and send the signal to the processor.

In an embodiment of the disclosure, the mechanical key may include a tact key for generating a signal in response to physical push of the user.

In an embodiment of the disclosure, the processor may receive the signal generated in response to the physical push of the user and perform an operation according to the input of the user.

According to an embodiment of the disclosure, a home appliance including a common mounting region where a mechanical key and an electronic key may be mounted may include a user interface panel for displaying information relating to an operation of the home appliance and receiving a user input. In an embodiment of the disclosure, the home appliance may include a processor configured to control the home appliance based on the user input. In an embodiment of the disclosure, the home appliance may include a PCB used for the user interface panel. In an embodiment of the disclosure, the PCB may include a common mounting region where an electronic key or a mechanical key for input interface is allowed to be mounted. In an embodiment of the disclosure, the PCB may include a first jumper for connecting the common mounting region to the ground. In an embodiment of the disclosure, the common mounting region of the PCB may include a plurality of conductive planes to be coupled with terminals of the mechanical key. In an embodiment of the disclosure, when the electronic key is mounted in the common mounting region of the PCB, the first jumper may be opened, and when the mechanical key is mounted in the common mounting region, the first jumper may be short-circuited.

In an embodiment of the disclosure, the common mounting region may include a copper foil plane electrically connected to the electronic key, which is isolated from a plurality of conductive planes connected to the mechanical key.

In an embodiment of the disclosure, the plurality of conductive planes connected to the mechanical key may be electrically connected to a plurality of terminals of the mechanical key when the mechanical key is mounted on the PCB.

In an embodiment of the disclosure, the copper foil plane connected to the electronic key may be a remaining conductive plane other than the plurality of conductive planes connected to the plurality of terminals of the mechanical key.

In an embodiment of the disclosure, the copper foil plane connected to the electronic key may be coated with immutable ink and processed not to be exposed to the outside.

In an embodiment of the disclosure, the home appliance may further include a touch IC for detecting a touch, and the touch IC may detect a signal generated in response to the touch of the user on the electronic key when the electronic key is mounted in the common mounting region and send the signal to the processor through communication.

According to an embodiment of the disclosure, a method of manufacturing a PCB including a common mounting area allowed for a mechanical key and an electronic key to be mounted thereon in a washing machine is provided. The washing machine includes a door through which laundry is thrown in or drawn out, a drum receiving the laundry, a motor rotating the drum for doing the wash, a user interface panel providing information relating to washing of the laundry and receiving a user input and the PCB used for the user interface panel and including the common mounting region where the electronic key and the mechanical key are allowed to be mounted. In an embodiment of the disclosure, the method may include producing a copper clad laminate (CCL) panel by putting copper foil into upper and lower portions of a prepreg insulation layer and pressing it. In an embodiment of the disclosure, the method may include creating roughness on the produced CCL panel and laminating a dry film on the CCL panel. In an embodiment of the disclosure, the method may include forming a circuit image by putting a film including the common mounting region on the dry film and irradiating UV rays.

In an embodiment of the disclosure, in the method of manufacturing the PCB, a copper foil plane connected to the mechanical key in the common mounting region may include a plurality of conductive planes connected to a plurality of terminals of the mechanical key and a copper foil plane connected to the electronic key may be a remaining region other than the plurality of conductive planes.

In an embodiment of the disclosure, in the common mounting region, the plurality of conductive planes connected to the plurality of terminals of the mechanical key and the remaining region other than the plurality of conductive planes may be isolated from each other, and the plurality of conductive planes and the remaining region may form the same layer.

In an embodiment of the disclosure, the method may further include coating the remaining region of the copper foil connected to the electronic key with immutable ink not to be exposed to the outside.

In an embodiment of the disclosure, the method may include eliminating at least a portion of the dry film with an alkaline solution on the CCL panel on which the circuit image is formed.

In an embodiment of the disclosure, the method may include coating a surface of the CCL panel with solder resist ink.

In an embodiment of the disclosure, the method may include eliminating the solder resist ink coated on the plurality of conductive planes for the plurality of terminals of the mechanical key to be soldered on the plurality of conductive planes.

The method according to an embodiment of the disclosure may be implemented in program instructions which are executable by various computing means and recorded in computer-readable media. The computer-readable media may include program instructions, data files, data structures, etc., separately or in combination. The program instructions recorded on the computer-readable media may be designed and configured specially for the disclosure, or may be well-known to those of ordinary skill in the art of computer software. Examples of the computer readable recording medium include a magnetic medium such as a hard disk, a floppy disk and a magnetic tape, an optical medium such as a compact disc read-only memory (CD-ROM) and a digital versatile disc (DVD), a magneto-optical medium such as a floptical disk, and a hardware device specially configured to store and perform program instructions, such as a read-only memory (ROM), a random-access memory (RAM), a flash memory, etc. Examples of the program instructions include not only machine language codes but also high-level language codes which are executable by various computing means using an interpreter.

Some embodiments of the disclosure may be implemented in the form of a computer-readable recording medium that includes computer-executable instructions such as the program modules executed by the computer. The computer-readable medium may be an arbitrary available medium that may be accessed by the computer, including volatile, non-volatile, removable, and non-removable mediums. The computer-readable recording medium may also include a computer storage medium and a communication medium. The computer-readable medium includes all the volatile, non-volatile, removable, and non-removable mediums implemented by an arbitrary method or technology for storage of information, such as computer-readable instructions, data structures, program modules, or other data. The communication medium generally includes computer-readable instructions, data structures, program modules, or other data or other transmission mechanism for modulated data signals like carrier waves, and include arbitrary information delivery medium. Furthermore, some embodiments of the disclosure may be implemented in a computer program or a computer program product including computer-executable instructions.

The machine-readable storage medium may be provided in the form of a non-transitory storage medium. The term 'non-transitory storage medium' may mean a tangible device without including a signal, e.g., electromagnetic waves, and may not distinguish between storing data in the storage medium semi-permanently and temporarily. For example, the non-transitory storage medium may include a buffer that temporarily stores data.

In an embodiment of the disclosure, the aforementioned method according to the various embodiments of the disclosure may be provided in a computer program product. The computer program product may be a commercial product that may be traded between a seller and a buyer. The computer program product may be distributed in the form of a machine-readable storage medium (e.g., a CD-ROM) or distributed directly between two user devices (e.g., smart phones) or online (e.g., downloaded or uploaded). In the case of the online distribution, at least part of the computer program product (e.g., a downloadable app) may be at least temporarily stored or arbitrarily created in a storage medium that may be readable to a device such as a server of the manufacturer, a server of the application store, or a relay server.

## Claims

1. A washing machine comprising:
a door through which laundry is loaded in or drawn out;
a drum configured to receive the laundry;
a motor rotating the drum configured to perform a wash of the laundry;
a user interface panel configured to provide information relating to washing of the laundry and to receive a user input;
a processor configured to drive the motor or control the motor to perform the wash based on the user input,;
wherein the user interface panel includes a printed circuit board (PCB)comprising:
a common mounting region allowing an electronic key or a mechanical key for input interface to be mounted thereon; and
a first jumper connecting the common mounting region to ground, and
wherein the common mounting region comprises a plurality of conductive planes.

2. The washing machine of claim 1, wherein the plurality of conductive planes are configured to be coupled to a plurality of terminals of the mechanical key, and wherein the first jumper is short-circuited when the mechanical key is mounted in the common mounting region.

3. The washing machine of claims 1 or 2, wherein the first jumper is opened when the electronic key is mounted in the common mounting region.

4. The washing machine of claim 1, wherein the first jumper is opened or short-circuited when the electronic key is mounted in the common mounting region and does not contact the plurality of conductive planes.

5. The washing machine of any one of claims 1 to 4, wherein the common mounting region comprises a copper foil plane electrically connected to the electronic key, which is isolated from the plurality of conductive planes connected to the mechanical key.

6. The washing machine of any one of claims 1 to 5, wherein the copper foil plane electrically connected to the electronic key and the plurality of conductive planes connected to the mechanical key form a same layer.

7. The washing machine of claim 6, wherein the plurality of conductive planes connected to the mechanical key are electrically connected to the plurality of terminals of the mechanical key when the mechanical key is mounted on the PCB.

8. The washing machine of claim 7, wherein the copper foil plane connected to the electronic key is a remaining conductive plane other than the plurality of conductive planes connected to the plurality of terminals of the mechanical key.

9. The washing machine of claim 8, wherein the copper foil plane connected to the electronic key is processed not to be exposed to outside by being coated with immutable ink.

10. The washing machine of any one of claims 1 to 9, wherein the electronic key comprises a touch key which generates a signal in response to a touch of a user.

11. The washing machine of claim 10, wherein the touch key comprises at least one of a touch gasket, a touch spring and a conductor bar as an electrode to connect a touch panel on which a touch is made in a touch input scheme to the PCB used for the user interface panel.

12. The washing machine of claim 10, further comprising a touch integrated circuit (IC) configured to detect a touch,
wherein the signal generated in response to the touch of a user is detected and transmitted by the touch IC to the processor through signal communication.

13. The washing machine of any one of claims 1 to 12, wherein the mechanical key comprises a tact key which generates a signal in response to a physical push of a user.

14. The washing machine of claim 13, wherein the signal generated in response to the physical push of the user is received by the processor to perform an operation according to the input of the user.

15. A home appliance comprising:
a user interface panel displaying information relating to an operation of the home appliance and receiving a user input;
a processor configured to control the home appliance based on the user input; and
a printed circuit board (PCB) used for the user interface panel,
wherein the PCB comprises:
a common mounting region allowing an electronic key or a mechanical key for input interface to be mounted thereon; and
a first jumper connecting the common mounting region to ground,
wherein the common mounting region comprises a plurality of conductive planes to be coupled to a plurality of terminals of the mechanical key, and wherein the first jumper is opened when the electronic key is mounted in the common mounting region and the first jumper is short-circuited when the mechanical key is mounted in the common mounting region.
